# EUROPEAN PATENT APPLICATION

(11) **EP 4 318 943 A1**
(43) Date of publication of application: **07.02.2024**
(21) Application number: 23179852.1
(22) Date of filing: 16.06.2023
(51) Int. Cl.: H03F 3/60, H03F 3/45, H03F 1/56

(54) **SIGNAL TERMINATION FOR AMPLIFIERS**

(30) Priority: 05.08.2022 US 202217817814
(71) Applicant: Semtech Corporation, Camarillo, CA 93012 (US)
(72) Inventor: DUFF, Christopher Iain, Lancashire (GB)
(74) Representative: Haseltine Lake Kempner LLP

(57) **Abstract**

Amplifier circuitry is disclosed for receiving a differential signal and outputting a single-ended output signal. A travelling wave amplifier (101) has a plurality of amplifier elements (102) connected between an input transmission line (103) and an output transmission line (104), each extending between first and second sides of the travelling wave amplifier (101). The input transmission line (103) is configured to receive the first differential signal component at the first side and the output transmission line (104) is configured to provide the single-ended output signal at the second side. A matched transmission line (202), which is configured to match at least some transmission properties of the input transmission line (103), receive the second differential signal component at the first end. A differential termination network (201) is connected to both the input transmission line (103) and the matched transmission line (202) and is configured to provide differential termination of signals received at the first and second termination inputs.

## Description

### Technical Field

The present disclosure is related to apparatus and methods for signal termination, in particular for signal termination in differential to single-ended amplifiers and especially to amplifiers arrangements having a travelling wave amplifier.

### Background

There are various applications where amplification of broadband RF input signals is desirable, for instance for drivers for data transmission, which could be optical drivers, such as EML drivers or the like, in which an input electrical signal may be amplified to driver a suitable laser modulator. In such applications, a distributed travelling wave structure may be used to provide broadband amplification, as a travelling wave amplifier (TWA) can provide gain over a wide range from DC up to relatively high frequencies.

In some cases, it may be desirable for the amplifier to have a differential input configuration, for instance due to a signal source topology. A differential input can also be beneficial, compared to a single-ended configuration, in providing common-mode input signal rejection and increased immunity to local or environmental noise.

Whilst a differential TWA could be implemented to provide broadband amplification of an input differential signal, in at least some applications only a single-ended output signal may be sufficient, in which case it may to preferable to implement a single-ended TWA, so as to save on power consumption and also circuit area. In this case, an initial input stage differential amplifier may be arranged to receive the differential input signal, to preserve the benefits of the differential input, with one output of the input stage amplifier being provided as an input for the TWA and the other differential output of the input stage amplifier being terminated.

Whilst such an amplifier arrangement can be used to provide good performance, in general there is an ongoing desire to reduce the size and/or cost of circuitry.

### Summary

Embodiments of the present disclosure relate to methods and apparatus for termination of signals in an amplifier arrangement, in particular for signal termination in a differential input, single-ended output, amplifier arrangement comprising a travelling wave amplifier.

According to some embodiments there is provided amplifier circuitry for receiving first and second differential signal components of a differential signal and outputting a single-ended output signal. The amplifier circuity comprises a travelling wave amplifier comprising a plurality of amplifier elements connected between an input transmission line and an output transmission line, each transmission line extending between first and second sides of the travelling wave amplifier. The input transmission line is configured to receive the first differential signal component at the first side and the output transmission line is configured to provide the single-ended output signal at the second side. A matched transmission line, configured to match at least some transmission properties of the input transmission line of the travelling wave amplifier, extends between first and second ends and is configured to receive the second differential signal component at the first end. A differential termination network with first and second termination inputs connected respectively to the input transmission line at the second side of the travelling wave amplifier and to the second end of the matched transmission line, is configured to provide differential termination of signals received at the first and second termination inputs.

In some examples the amplifier circuitry may further comprise an input stage differential amplifier configured to receive a differential input signal and output said first and second differential signal components.

In some examples, the differential termination network may comprise a symmetrical resistor arrangement connected in series between the first and second termination inputs. The differential termination network may further comprise a decoupling network for termination of any common-mode component of the signals received at the first and second termination inputs. The decoupling network may comprise at least one capacitor connected between a midpoint of the symmetrical resistor arrangement and a defined voltage. The decoupling network may further comprise at least one resistor in series with said first capacitor.

The amplifier circuitry may be formed as an integrated circuit on an integrated circuit die. The differential termination network may further comprise a connection for connecting to a decoupling network external to the integrated circuit die.

In some examples, the matched transmission line may comprise an artificial transmission line having a characteristic impedance and electrical length matched to that of the input transmission line of the travelling wave amplifier. In some examples, the matched transmission line may comprise an alternating sequence of high impedance line sections and shunt capacitors to a defined voltage. The shunt capacitors may be configured to have a capacitance value that matches a capacitance of an input to an amplifier element of the travelling wave amplifier.

In some examples, the amplifier elements of the travelling wave amplifier may comprise transistor, and the input transmission line may comprise an artificial transmission line connecting a gate or base terminal of the transistors. The output transmission line may comprise an artificial transmission line connecting a drain or collector terminal of the transistors. A source or emitter terminal of the transistors may be connected to a defined voltage.

In some examples, the amplifier circuitry may further comprise a further termination network having a further termination input connected to the output transmission line at the first side of the travelling wave amplifier to terminate any signal received at the further termination input.

Aspects also relate to an electronic device comprising the amplifier circuitry of any of the embodiments described herein.

In a further aspect there is provided amplifier circuitry comprising an input differential amplifier with first and second differential inputs for receiving a differential input signal and first and second outputs for outputting a corresponding differential output signal and a travelling wave amplifier having an input transmission line and an output transmission line. A first end of the input transmission line is connected to said first output of the input differential amplifier. A matched transmission line is configured to match at least some transmission properties of the input transmission line of the travelling wave amplifier, and a first end of the matched transmission line is connected to the second output of the input differential amplifier. A differential termination network is connected to a second end of the input transmission line and to a second end of the matched transmission line.

In some examples, the differential termination network may comprise a resistor arrangement configured to terminate any differential component of signals at the second end of the input transmission line and the second end of the matched transmission line. The differential termination network may further comprise a decoupling network configured to terminate any common-mode component of signals at the second end of the input transmission line and the second end of the matched transmission line. The amplifier circuitry may be formed as an integrated circuit on an integrated circuit die, and the differential termination network may further comprise a connection for connecting to a decoupling network external to the integrated circuit die.

In a further aspect there is provided amplifier circuitry comprising a travelling wave amplifier have an input transmission line configured to receive a first differential signal component of a differential signal, an additional transmission line configured to receive a second differential signal component of said differential signal, and a termination network coupled to the input transmission line and the additional transmission line and configured to differentially terminate signals received from the input transmission line and the additional transmission line.

The additional transmission line may comprise an artificial transmission line having a characteristic impedance and electrical length matched to that of the input transmission line of the travelling wave amplifier. The amplifier circuitry may further comprise an input stage differential amplifier configured to receive a differential input signal and output said first and second differential signal components.

### Brief Description of the Drawings

To better explain various embodiments and examples of the present disclosure and the principles, example implementation and operation thereof, reference will now be made, by way of example, to the following drawings, in which:
Figure 1 illustrates an example of differential input to single-ended output amplifier with a travelling wave amplifier; and
Figure 2 illustrates an example of differential input to single-ended output amplifier with a travelling wave amplifier according to an embodiment.

### Detailed Description

Embodiments of the present disclosure relate to methods and apparatus for signal termination in a differential to single-ended amplifier configuration, and especially to such amplifier arrangements comprising a travelling wave amplifier structure.

As discussed above a travelling wave amplifier (TWA) structure may be used to provide broadband amplification for some application.

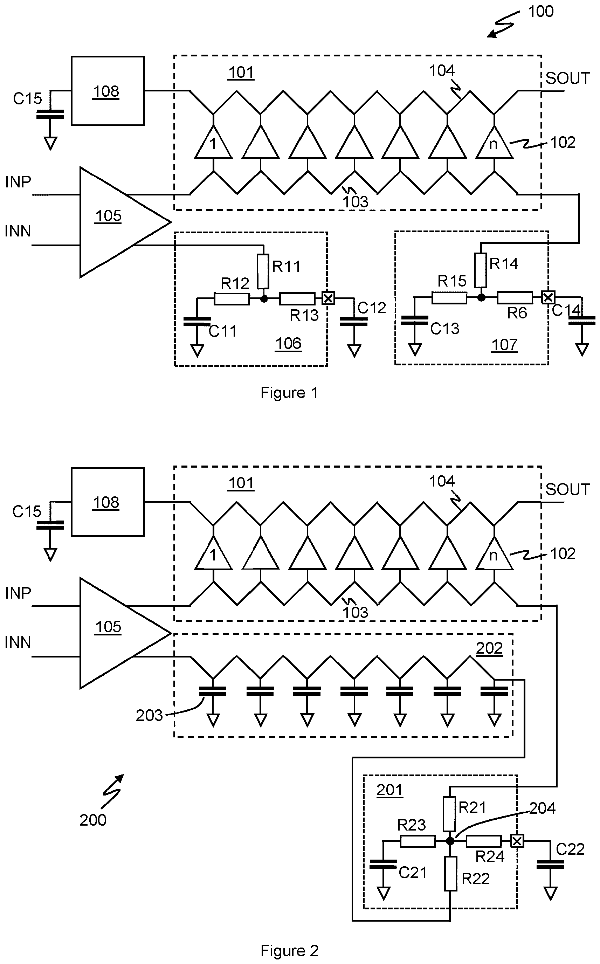

**Figure 1** illustrates one example of an amplifier apparatus 100 including a TWA 101.

As will be understood by one skilled in the art, a TWA can be implemented by a plurality (1 - n) of amplifier elements 102 with inputs connected to a common input transmission line 103 and outputs connected to a common output transmission line 104. Typically the amplifier elements 102 may be implemented by suitable transistors, such as FETs, with their gates connected to the input transmission line 103, which may be implemented as an artificial transmission line (sometimes referred to as the gate line) and their drains connected to the output transmission line 104, which may be implemented as an artificial transmission line (sometimes referred to as the drain line). As will be understood by one skilled in the art, an artificial transmission line is typically a signal propagation path implemented with lumped elements, typically inductors and/or capacitors, to replicate or approximate the behavior of a transmission line and thus the gate line and drain line may have tuned inductances (not separately illustrated) between the successive transistors along the gate line 103 and drain line 104 respectively. Note that as used herein, the term transmission line shall be taken to mean any suitable type of propagation path for propagation of the input and output signals of the travelling wave amplifier. The sources or emitters of the transistors in such a TWA are generally connected to a defined voltage, typically ground.

The input for the TWA 101 can be applied to the input transmission line 103 on a first side of the TWA, i.e. applied to the gate line upstream of the first amplifier element, with the output signal, SOUT, being taken from the output transmission line 104 on the second (opposite) side of the TWA, i.e. from the drain line downstream of the nth amplifier element. In the example of figure 1, the TWA 101 provides a single-ended output signal SOUT. Whilst a differential TWA arrangement could be implemented, in many applications a single-ended output (with reference to the local circuit ground) may be acceptable and implementing a single-ended TWA can save circuit area and costs, and also power consumption in use, compared with a fully differential implementation.

However, it may be beneficial for the input to the amplifier arrangement 100 to be a differential input signal, i.e. provided by first and second differential input signal components INP and INN. As noted above, a differential configuration for the input signal may be preferable due to a signal source topology and/or providing common-mode input signal rejection and increased immunity to local or environmental noise.

Whilst one of the differential input signal components, say INP, could be supplied directly to the input of the TWA 101, in the example of figure 1 there is an input stage differential amplifier 105 provided to preserve the benefits of a differential input. The input stage differential amplifier 105 may be any suitable differential amplifier for the intended use case. A first output of the input stage differential amplifier 105 is supplied to the input of the TWA 101. The second output of the input stage differential amplifier 105 may be terminated.

Whilst the second output of the input stage differential amplifier 105 could be simply terminated by a connection to ground via a defined resistance, such a termination arrangement would lead to a DC current to ground in use, with an associated power loss. It is therefore preferable to provide an AC coupled resistive termination network comprising capacitance and resistance, that provides a tuned impedance to prevent unwanted signal reflection but without a DC current flow to ground.

Whilst, the required components of the termination network, i.e. resistors and capacitors, could be implemented as part of an integrated circuit with the TWA 101 and input stage differential amplifier 105, the value of capacitance required to provide good broadband termination performance down to low frequencies may be relatively high, and implementing such a capacitor as an internal, i.e. on-chip component, may not be practical in terms of the required circuit area and cost. Therefore at least some capacitance for the termination network may be provided by one or more off-chip components, i.e. an external component to the integrated circuit die. Figure 1 illustrates that second output of the input stage differential amplifier 105 may be supplied to an on-chip termination network 106 comprising resistances R11, R12 and R13 and an on-chip capacitance C11, with a connection for external, i.e. off-chip, capacitance, represented by C12. Note that figure 1 illustrates C12 as a single capacitance for simplicity, but in practice C12 may comprise a decoupling capacitor network, as will be understood by one skilled in the art.

In the arrangement of figure 1, it is also desirable to terminate the input transmission line 102 at the second side of the TWA, i.e. downstream of the nth amplifier element, using a termination network 107, to prevent unwanted signal reflection along the input transmission line. Again, an AC coupled resistive termination network may be preferred, to avoid power loss due to any DC termination current, which again may require at least some external, or off-chip, capacitance. Figure 1 illustrates that the input transmission line 103 at the second end of the TWA 101 may be coupled to an on-chip termination network 107 comprising resistances R13, R14 and R15 and an on-chip capacitance C13, with a connection for external, i.e. off-chip, capacitance, represented as C14 (which may be a decoupling capacitor network), to provide suitable termination.

For this arrangement of TWA is it also advantageous to terminate the output transmission line 104 on the first side of the TWA to terminate any signal propagating in the reverse direction along the output transmission line 104. Thus, the output transmission line 104 may be connected, on the first side of the TWA, to an on-chip termination network 108, which may for instance have a similar arrangement of resistances and capacitance as the termination network 107, and which is also connected to external capacitance C15.

Whilst the differential-to-single-ended amplifier arrangement 100 illustrated in figure 1 can provide good performance, the presence of the various termination networks 106, 107 and 108, together with the requirement for connections to external components, i.e. capacitances C2, C4 and C5, add to the size and cost of the circuit. In general, there is a desire to reduce circuit area where possible, for size and cost reasons.

In embodiments of the present disclosure a differential termination is used so as to allow a reduction in circuit area. Differential termination can also be advantageous in reducing the impact of any parasitic inductances.

**Figure 2** illustrates one example of the amplifier apparatus 200 according to an embodiment, in which similar components as discussed with reference to figure 1 are identified using the same reference numerals.

In the example of figure 2, a single-ended TWA 101 is provided, with an input stage differential amplifier 105 again provided to receive a differential input, INP and INN, and thus provides the benefits of a differential input. A first output of the input stage differential amplifier 105 is input to the input transmission line (gate line) 103 on a first side of the TWA 101 and the output signal SOUT is taken from the output transmission line (drain line) 104 on a second side of the TWA.

In the example of figure 2, however, the second output of the input stage differential amplifier 105 is differentially terminated together with the second side of the input transmission line 103 of the TWA 101 (through which the signal from the first output of the input stage differential amplifier 105 propagates).

The second side of the input transmission line 103 of the TWA 101 is thus coupled to a first termination input of a differential termination network 201, whilst a signal derived from the second output of the input stage differential amplifier 105 is supplied to a second termination input of the differential termination network 201.

The first input to the differential termination network 201 is thus the first output of the input stage differential amplifier 105 (i.e. a first differential signal component of a differential signal) after propagation along the input transmission line 103 (i.e. the input propagation path along the gate line) of the TWA 101. To allow for differential termination, the second output of input stage differential amplifier 105 (i.e. the second differential signal component of the differential signal output from the initial stage differential amplifier 105) is thus supplied to a first end of an additional transmission line 202, which may also be implemented as an artificial transmission line, with a second end of the additional transmission line 202 being connected to the second termination input. The additional transmission line 202 is configured to prorogate a travelling wave in a similar manner to the gate line 103 of the TWA, i.e. to effectively match the properties of the gate line 103, and thus will be referred to herein as the matched transmission line. The matched transmission line 202 can be formed from a transmission line of similar characteristic impedance, electrical length and propagation characteristics as the input line 103 of the TWA 101. In some cases the matched transmission line 202 may be formed, as illustrated in figure 2, by alternating sections of high impedance lines and shunt capacitors 203 to ground, in a similar configuration as the input transmission line 103 of the TWA 101. The shunt capacitors 203 can be formed such that they are similar in capacitance value to the transistor inputs of TWA 101 at the quiescent bias point. The shunt capacitors 203, together with the high impedance line segments, can be tuned to exhibit similar broadband characteristic impedance, electrical length and propagation characteristics as the input transmission line 103 of the TWA 101. As used herein, the term matching, with reference to the transmission lines, shall be taken to mean that at least some of the propagation characteristics of the transmission lines are configured to be similar, and it will be understood that the properties of the transmission lines need not be exactly the same as one another to be matching, although preferably the relevant properties may match relatively closely, e.g. within a defined tolerance.

Using such a matched transmission line 202, which is effectively matched to the properties of the input transmission line 103 of the TWA, means that the travelling waves from the first and second outputs of the input stage differential amplifier 105 can arrive differentially at the first and second termination inputs to the differential termination network 201.

The differential termination network 201 may comprise some on-chip resistances and capacitances. For differential termination, a symmetrical resistor network may be arranged in series between the first and second termination inputs, in this example matched resistors R21 and R22. For purely differential inputs to the differential termination network 201, the midpoint node 204, which connects R21 and R22 in symmetrical network, would be a virtual ground and the differential signals will terminate.

However, in practice, the differential inputs to the differential termination network 201 may comprise some common-mode component. For instance there may be some common-mode component in the input signal components INP and INP and/or some common-mode component may arise due to any mismatches within the various circuit paths, e.g. due to operation of the input stage differential amplifier 105 and/or any differences between the TWA input transmission line 103 and the matched transmission line 201.

To provide termination of any common-mode component, on-chip decoupling capacitor C21 may be provided, in this example connected to the midpoint node 204 via resistor R23. In some cases, it may not practically be possible to provide sufficient capacitance on-chip to provide suitable termination down to very low frequencies, and thus the on-chip differential termination network 201 may also have a connection for connecting, in this case via resistor R24, to an external capacitance, represented as C22, but which may comprise a capacitor network. Note that resistors R23 and R24 are provided as de-Q resistors, i.e. to reduce the quality factor so as to provide resonance damping, and these resistors could be omitted in some embodiments.

Implementing differential termination in this way, allows the second output from the input stage differential amplifier 105 to be terminated using the same termination network as used for the input transmission line 103 of the TWA, which can save on circuit area and cost. The differential termination network 201 illustrated in figure 2 has just one connection for an external capacitance C22, compared with the two separate external connection for each of termination networks 105 and 106 as illustrated in figure 1. Reducing the connections required for external components can save on circuit area. In addition, the one on-chip capacitance C21 differential termination network 201 may provide area savings compared to the two on-chip capacitances C11 and C13 discussed with reference to figure 1, especially as the capacitor decoupling for the differential termination need only cope with any common-mode component, as may the reduced resistor count for the differential termination network compared to the two single-ended termination network.

Providing differential termination as illustrated in figure 2 does involve the presence of matched transmission line 202, but this matched transmission line 202 can be implemented in a relatively small area and the overall circuit area savings discussed above can significantly outweigh the extra area required for the matched transmission line 202. It will also be understood that the matched transmission line 202 can be implemented using passive components and thus has no significant impact on power consumption.

In addition, differential termination of these signals means that most of the signal energy may be terminated differential on-chip, rather than via the use of off-chip decoupling capacitors, which can be advantageous. For the single-ended termination networks 106 and 107 discussed with reference to figure 1, a significant proportion of the signal energy may effectively be terminated by the off-chip decoupling capacitor networks C12 and C14. This can mean that a relatively significant current may flow via the off-chip connection. The single-ended termination networks 106 and 107 discussed with reference to figure 1 may thus typically be implemented with relatively close spacing between the integrated circuit die and the off-chip decoupling, so as to generally minimize the impact of any parasitic inductance associated with the chip bonding and PCB traces etc. and to provide a flat amplifier frequency response. For differential termination, most of the signal energy may be terminated differentially on-chip, and only any common-mode component, which may be relatively limited, may require the off-chip decoupling. Thus, the current flowing via the off-chip connection may be significantly lower for the differential termination discussed with reference to figure 2. As such, the impact of any parasitic inductance etc. associated with the off-chip connection may be significantly lower. This can ease tolerances for clearances etc. associated the off-chip decoupling network, which can enable relaxed circuit board design and easier and lower cost assembly. The effect of any parasitics of on-chip components will also, in general, be lower for differential termination.

It will be understood that, as illustrated in figure 2, appropriate termination may still be required for the output transmission line 104 of the TWA 101 at the first side, which can be provided by a single-ended termination network 108 such as discussed with reference to figure 1.

The embodiment discussed with reference to figure 2 has an input stage differential amplifier 105 arranged to receive the input differential signal components INP and INN and provide first and second differential signal components for the input transmission line 103 of the TWA 101 and the matched transmission line 202 respectively. It will be understood that, in some applications, some additional processing stages could be implemented, e.g. upstream of the input stage differential amplifier 105 or between the input stage differential amplifier 105 and the respective transmission lines 103 and 202. In some embodiments, the input stage differential amplifier 105 could be omitted, with the received input signal components being applied to the input line 103 of the TWA 101 and the matched transmission line 202 respectively without any initial stage amplification or with some other input stage processing.

In general, first and second differential signal components, derived from an input differential signal (i.e. which could be the input signal components themselves or processed, e.g. amplified, versions thereof), are applied to a TWA input transmission line and a matched transmission line respectively and the signals that propagate through the TWA input transmission line and the matched transmission line are terminated together differentially.

Embodiments of the present disclosure may be used for amplifiers for broadband amplification in signal drivers for communication. As noted, at least some embodiments may be suitable for use in optical drivers, e.g. for EML drivers for optical communications, or for some electrical communication drivers.

Embodiments may be implemented as an integrated circuit. Embodiments also relate to electronic devices including an amplifier arrangement as described herein.

It will be understood that the examples and embodiments described above are given by way of example only and those skilled in the art will understand that modifications, variations, additions or alterations may be made to specific embodiments described, or alternative embodiments may be implemented, without departing from the scope of the appended claims.

It should be noted that as used herein, unless expressly stated otherwise, the word "comprising" does not exclude the presence of other elements or steps other than those listed, references to an element or feature in the singular does not exclude the possibility of a plurality of such elements or features, and that recitation of different features or elements in the appended claims does not necessarily imply separate components; a single component or unit may fulfil the function of several elements recited in a claim. Any reference signs in the appended claims shall not be construed so as to limit their scope.

## Claims

1. Amplifier circuitry for receiving first and second differential signal components of a differential signal and outputting a single-ended output signal, the amplifier circuity comprising:
a travelling wave amplifier comprising a plurality of amplifier elements connected between an input transmission line and an output transmission line, each extending between first and second sides of the travelling wave amplifier, wherein the input transmission line is configured to receive the first differential signal component at the first side and wherein the output transmission line is configured to provide the single-ended output signal at the second side;
a matched transmission line configured to match at least some transmission properties of the input transmission line of the travelling wave amplifier, wherein the matched transmission line extends between first and second ends and is configured to receive the second differential signal component at the first end; and
a differential termination network with first and second termination inputs connected respectively to the input transmission line at the second side of the travelling wave amplifier and to the second end of the matched transmission line, the differential termination network being configured to provide differential termination of signals received at the first and second termination inputs.

2. The amplifier circuitry of claim 1 further comprising an input stage differential amplifier configured to receive a differential input signal and output said first and second differential signal components.

3. The amplifier circuitry of claim 1 or claim 2 wherein the differential termination network comprises a symmetrical resistor arrangement connected in series between the first and second termination inputs.

4. The amplifier circuitry of claim 3 wherein the differential termination network further comprises a decoupling network for termination of any common-mode component of the signals received at the first and second termination inputs.

5. The amplifier circuitry of claim 4 wherein the decoupling network comprises at least one capacitor connected between a midpoint of the symmetrical resistor arrangement and a defined voltage.

6. The amplifier circuitry of claim 5 wherein the decoupling network further comprises at least one resistor in series with said first capacitor.

7. The amplifier circuitry of any of claims 3 to 6 formed as an integrated circuit on an integrated circuit die, where the differential termination network further comprises a connection for connecting to a decoupling network external to the integrated circuit die.

8. The amplifier circuitry of any preceding claim wherein the matched transmission line comprises an artificial transmission line having a characteristic impedance and electrical length matched to that of the input transmission line of the travelling wave amplifier.

9. The amplifier circuitry of any preceding claim wherein the matched transmission line comprises an alternating sequence of high impedance line sections and shunt capacitors to a defined voltage.

10. The amplifier circuitry of any preceding claim wherein the shunt capacitors are configured to have a capacitance value that matches a capacitance of an input to an amplifier element of the travelling wave amplifier.

11. The amplifier circuitry of any preceding claim wherein the amplifier elements of the travelling wave amplifier comprise transistors, and wherein the input transmission line comprises an artificial transmission line connecting a gate or base terminal of said transistors, the output transmission line comprises an artificial transmission line connecting a drain or collector terminal of said transistors, and a source or emitter terminal of said transistors is connected to a defined voltage.

12. The amplifier circuitry of any preceding claim further comprising a further termination network having a further termination input connected to the output transmission line at the first side of the travelling wave amplifier to terminate any signal received at the further termination input.

13. An electronic device comprising the amplifier circuitry of any preceding claim.
